# EUROPEAN PATENT APPLICATION

(11) **EP 4 839 050 A1**
(43) Date of publication of application: **11.11.2026**
(21) Application number: 25802465.2
(22) Date of filing: 22.04.2025
(51) Int. Cl.: H10F 10/14, H10F 77/14

(54) **SOLAR CELL, CELL MODULE AND PHOTOVOLTAIC SYSTEM**

(30) Priority: 15.05.2024 CN 202410606254
(71) Applicant: Zhuhai Fushan Aiko Solar Energy Technology Co., Ltd., FushanIndustrial Park, Doumen District Zhuhai Guangdong 519000 (CN); Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, Junkai, Jinhua, Zhejiang 322000 (CN); PAN, Junming, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2025/090492
(87) International publication number: WO 2025/237016

(57) **Abstract**

The present disclosure is suitable for the technical field of solar cells. Provided are a solar cell, a solar module, and a photovoltaic system. The solar cell includes a silicon substrate. The silicon substrate includes a central region and a corner edge region; a conduction type of the central region and a conduction type of the corner edge region are the same; a ratio of resistivity of the corner edge region to resistivity of the central region is greater than or equal to 1.2; and the resistivity of the central region is greater than or equal to 100 Ω·cm.

## Description

### Cross-Reference to Related Application

This application claims priority to Chinese Patent Application No. 202410606254.1 filled to the China National Intellectual Property Administration on May 15, 2024 and entitled "Solar Cell, Solar Module, and Photovoltaic System", the disclosure of which is hereby incorporated by reference in its entirety.

### Technical Field

The present disclosure relates to the technical field of solar batteries, and in particular, to a solar cell, a solar module, and a photovoltaic system.

### Background

A solar cell converts sunlight into electric energy, and is generally made based on a silicon substrate. The silicon substrate may be an N-type silicon substrate or a P-type silicon substrate. In the related art, the silicon substrate generally has relatively uniform resistivity in a center and on an edge, and has a high doping concentration. However, after the solar cell is manufactured, the compounding of the silicon substrate is relatively serious. Based on this, how to reduce the compounding of a silicon substrate in a solar cell becomes an urgent problem to be resolved.

### Summary

The present disclosure provides a solar cell, a solar module, and a photovoltaic system, so as to solve the technical problem of how to reduce the compounding of a silicon substrate in a solar cell.

The present disclosure is implemented in the following way. The solar cell in the embodiments of the present disclosure includes a silicon substrate. The silicon substrate includes a central region and a corner edge region; a conduction type of the central region and a conduction type of the corner edge region are the same; a ratio of resistivity of the corner edge region to resistivity of the central region is greater than or equal to 1.2; and the resistivity of the central region is greater than or equal to 100 Ω▪cm.

Specifically, the conduction types of the central region and the corner edge region both are N types, the central region and the corner edge region include at least one N-type doping element, and the N-type doping element includes at least one element in Group V elements and Group VI elements.

Specifically, the conduction types of the central region and the corner edge region both are P types, the central region and the corner edge region include at least one P-type doping element, and the P-type doping element includes at least one element in Group III elements.

Specifically, a projection of the central region onto a surface of the silicon substrate perpendicular to a thickness direction of the silicon substrate is circular, a center of circle is a central point of the silicon substrate, and a radius is 1/5-1/2 of a side length of the silicon substrate.

Specifically, the corner edge region includes a first corner side and a second corner side, a length of the first corner side is 1/100-1/2 of a side length of the silicon substrate, and a length of the second corner side is 1/100-1/2 of the side length of the silicon substrate.

Specifically, resistivity of the corner edge region is greater than or equal to 500 Ω▪cm.

Specifically, an acceptor impurity concentration of the corner edge region is less than an acceptor impurity concentration of the central region.

Specifically, a ratio of an acceptor impurity concentration of the central region to an acceptor impurity concentration of the corner edge region is 1.01-10.

Specifically, the conduction types of the central region and the corner edge region both are P types, doping elements in the central region and the corner edge region all include at least one P-type doping element and at least one N-type doping element, a doping concentration of the at least one P-type doping element in the central region is greater than a doping concentration of the at least one N-type doping element in the central region, and a doping concentration of the at least one P-type doping element in the corner edge region is greater than a doping concentration of the at least one N-type doping element in the corner edge region, a slope absolute value of a concentration curve of the at least one P-type doping element is greater than a slope absolute value of a concentration curve of the at least one N-type doping element, a horizontal coordinate of the concentration curve of the at least one N-type doping element is a distance between a test position of the silicon substrate and a central point of the silicon substrate, and a vertical coordinate is a concentration of the at least one N-type doping element in the test position; and a horizontal coordinate of the concentration curve of the at least one P-type doping element is the distance between a test position and the central point of the silicon substrate, and a vertical coordinate is a concentration of the P-type doping element in the test position.

Specifically, the slope absolute value of the concentration curve of the at least one N-type doping element and the slope absolute value of the concentration curve of the at least one P-type doping element meet the following formula: ${K}_{2} > 1.2 {K}_{1} .$

Where K₁ is the slope absolute value of the concentration curve of the at least one N-type doping element, and K₂ is the slope absolute value of the concentration curve of the at least one P-type doping element.

Specifically, the conduction types of the central region and the corner edge region both are N types, doping elements in the central region and the corner edge region all includes P-type doping elements and N-type doping elements, a doping concentration of the at least one N-type doping element in the central region is greater than a doping concentration of the at least one P-type doping element in the central region, and a doping concentration of the at least one N-type doping element in the corner edge region is greater than a doping concentration of the at least one P-type doping element in the corner edge region.

A slope absolute value of a concentration curve of the at least one N-type doping element is greater than a slope absolute value of a concentration curve of the at least one P-type doping element.

A horizontal coordinate of the concentration curve of the at least one N-type doping element is a distance between a test position of the silicon substrate and a central point of the silicon substrate, and a vertical coordinate is a concentration of the at least one N-type doping element in the test position; and a horizontal coordinate of the concentration curve of the at least one P-type doping element is the distance between a test position and the central point of the silicon substrate, and a vertical coordinate is a concentration of the at least one P-type doping element in the test position.

Specifically, the slope absolute value of the concentration curve of the at least one N-type doping element and the slope absolute value of the concentration curve of the at least one P-type doping element meet the following formula: ${K}_{1} > 1.2 {K}_{2} .$

Where K₁ is the slope absolute value of the concentration curve of the at least one N-type doping element, and K₂ is the slope absolute value of the concentration curve of the at least one P-type doping element.

The present disclosure further provides a solar module, including the solar cell described in any one of the above.

The present disclosure further provides a photovoltaic system, including the above solar module.

In the solar cell, the solar module, and the photovoltaic system in the embodiments of the present disclosure, since the conduction types of the central region and the corner edge region of the silicon substrate are the same, the ratio of the resistivity of the corner edge region to the resistivity of the central region is greater than or equal to 1.2, and the resistivity of the central region is greater than or equal to 100 Ω▪cm, it can ensure that there are fewer P-type doping elements or N-type doping elements in the central region and the corner edge region, such that the overall doping concentration of the silicon substrate is reduced, and compounding pairs formed by the doping elements and oxygen and the compounding caused by the doping elements themselves are reduced. Furthermore, the resistivity of the corner edge region is greater than the resistivity of the central region, such that the concentration of the at least one P-type doping element or N-type doping elements in the corner edge region is further reduced, thereby further reducing the compounding pairs formed by the doping elements in the corner edge region and oxygen and the compounding caused by the doping elements themselves, and further improving conversion efficiency.

Additional aspects and advantages of the present disclosure will be partially set forth in the following description, and in part will be apparent from the following description, or may be learned by practice of the present disclosure.

### Brief Description of the Drawings

Fig. 1 is a schematic structural diagram of a solar cell according to an embodiment of the present disclosure.
Fig. 2 is a schematic structural diagram of a silicon substrate of a solar cell according to an embodiment of the present disclosure.
Fig. 3 is a schematic structural diagram of a silicon substrate of a solar cell according to an embodiment of the present disclosure.
Fig. 4 is a schematic structural diagram of a silicon substrate of a solar cell according to an embodiment of the present disclosure.
Fig. 5 is a schematic structural diagram of a silicon substrate of a solar cell according to an embodiment of the present disclosure.
Fig. 6 is a schematic structural diagram of a solar cell according to an embodiment of the present disclosure.
Fig. 7 is a schematic structural diagram of a solar cell according to an embodiment of the present disclosure.
Fig. 8 is a schematic structural diagram of a solar cell according to an embodiment of the present disclosure.
Fig. 9 is a schematic diagram of doping concentration distribution of a silicon substrate of a solar cell according to an embodiment of the present disclosure.
Fig. 10 is a schematic diagram of doping concentration distribution of a silicon substrate of a solar cell according to an embodiment of the present disclosure.

In the drawings:
1000. Solar cell; 10. Silicon substrate; 11. Central region; 12. Corner edge region; 121. First corner side; 122. Second corner side; 13. Middle region; 14. Side edge region; 21. First doped layer; 22. First passivation layer; 23. Internal diffusion layer; 24. First passivation anti-reflection layer; 25. First electrode; 31. Second doped layer; 32. Second passivation anti-reflection layer; and 33. Second electrode.

### Detailed Description of the Embodiments

To make the objectives, technical solutions and advantages of the present disclosure clearer, the present disclosure is further described in detail with reference to the drawings and embodiments. Examples of the embodiments are shown in the accompanying drawings, where the same or similar reference numerals throughout the present disclosure represent the same or similar elements or the elements having the same or similar functions. The embodiments described below with reference to the accompanying drawings are exemplary, and are only intended to be illustrative of the present disclosure and cannot be construed as limiting the present disclosure. In addition, it should be understood that specific embodiments described herein are merely intended to explain the present disclosure instead of limiting the present disclosure.

In the description of the present disclosure, it should be understood that orientation or position relationships indicated by the terms such as "top", "bottom", "back", "front", and the like are based on orientation or position relationships shown in the accompanying drawings, and are used only for ease and brevity of illustration and description of the present disclosure, rather than indicating or implying that the mentioned apparatus or element needs to have a particular orientation or needs to be constructed and operated in a particular orientation. Therefore, such terms should not be construed as a limitation on the present disclosure.

In the present disclosure, unless otherwise explicitly specified and defined, a first feature being "over" or "below" a second feature may mean that the first feature and the second feature are in direct contact, or the first feature and the second feature are not in direct contact but are in contact through another feature therebetween. Moreover, the first feature being "over", "above", and "on" the second feature includes that the first feature is directly above or obliquely above the second feature, or merely means that the first feature has a larger horizontal height than the second feature. The first feature being "beneath", "under" and "below" the second feature including the first feature being right under or at an inclined lower portion of the second feature, or simply indicating that the horizontal height of the first feature is less than that of the second feature.

The following disclosure provides many different embodiments or examples for achieving different structures of the present disclosure. In order to simplify the present disclosure of the present disclosure, components and settings of specific examples are described below. Certainly, they are merely examples, and are not intended to limit the present disclosure. In addition, the present disclosure may repeat reference numerals and/or reference letters in different examples. The repetition is for the purpose of simplification and clarity, but does not indicate a relationship between the various embodiments and/or settings discussed. In addition, the present disclosure provides examples of various specific processes and materials, but those of ordinary skill in the art may be aware of the application of other processes and/or usage scenarios of other materials.

In the present disclosure, since conduction types of a central region and a corner edge region of a silicon substrate are the same, a ratio of resistivity of the corner edge region to resistivity of the central region is greater than or equal to 1.2, and the resistivity of the central region is greater than or equal to 100 Ω▪cm, it can ensure that there are fewer P-type doping elements or N-type doping elements in the central region and the corner edge region, such that the overall doping concentration of the silicon substrate is reduced, and compounding pairs formed by the doping elements and oxygen and the compounding caused by the doping elements themselves are reduced. Furthermore, the resistivity of the corner edge region is greater than the resistivity of the central region, such that the concentration of the at least one P-type doping element or the at least one N-type doping element in the corner edge region is further reduced, thereby further reducing the compounding pairs formed by the doping elements in the corner edge region and oxygen and the compounding caused by the doping elements themselves, and further improving conversion efficiency.

### Embodiment 1

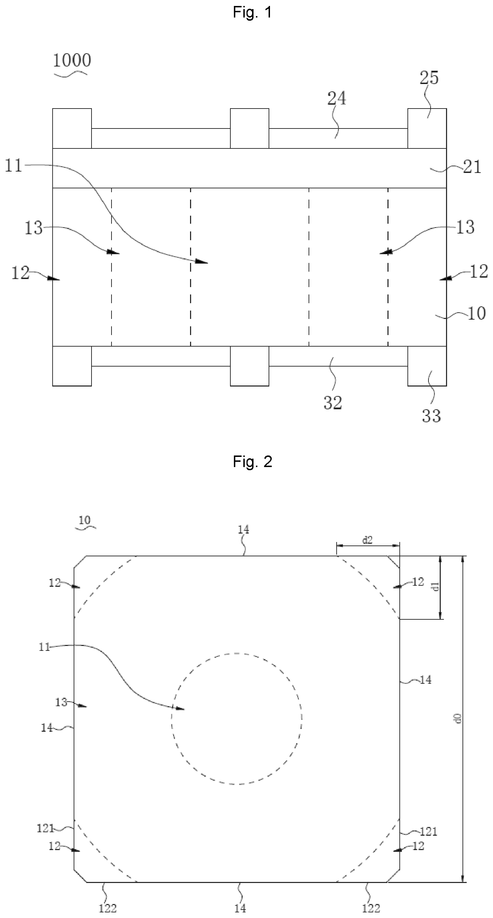

Referring to Fig. 1, Fig. 2, Fig. 3, Fig. 4, and Fig. 5, a solar cell 1000 in this embodiment of the present disclosure includes a silicon substrate 10. The silicon substrate 10 includes a central region 11 and a corner edge region 12; a conduction type of the central region 11 and a conduction type of the corner edge region 12 are the same; a ratio of resistivity of the corner edge region 12 to resistivity of the central region 11 is greater than or equal to 1.2; and the resistivity of the central region 11 is greater than or equal to 100 Ω▪cm.

In the solar cell 1000 in this embodiment of the present disclosure, since the conduction types of the central region 11 and the corner edge region 12 of the silicon substrate 10 are the same, the ratio of the resistivity of the corner edge region 12 to the resistivity of the central region 11 is greater than or equal to 1.2, and the resistivity of the central region 11 is greater than or equal to 100 Ω▪cm, it can ensure that there are fewer doping elements in the central region 11 and the corner edge region 12 (the doping elements are P-type doping elements or N-type doping elements), such that the overall doping concentration of the silicon substrate 10 is reduced, and compounding pairs formed by the doping elements and oxygen and the compounding caused by the doping elements themselves are reduced. Furthermore, the resistivity of the corner edge region 12 is greater than the resistivity of the central region 11, such that the concentration of the at least one P-type doping element or at least one N-type doping elements in the corner edge region 12 is further reduced, thereby further reducing the compounding pairs formed by the doping elements in the corner edge region 12 and oxygen and the compounding caused by the doping elements themselves, and further improving conversion efficiency.

Specifically, in some embodiments, the solar cell 1000 is a back contact cell, in some embodiments, is a double-sided contact cell. In some embodiments, the solar cell 1000 is a sing cell, in some embodiments, is a laminated cell. The solar cell 1000 can be an HJT cell, a PERC cell, or a TopCon cell, etc. A specific form of the solar cell 1000 is not limited herein.

In this embodiment, the conduction type of the central region 11 and the conduction type of the corner edge region 12 are the same, and both are P types. Therefore, in a process of manufacturing the solar cell 1000 based on the silicon substrate 10, contamination of copper ions to an edge of the silicon substrate 10 is withstood by using the P-type silicon substrate 10, thereby reducing compounding caused by the contamination of the copper ions to the edge of the silicon wafer 10.

It should be understood that, in other embodiments, the conduction type of the central region 11 and the conduction type of the corner edge region 12 are also the same, and both are N types. Therefore, a concentration of a dopant of the silicon substrate 10 is less, and bulk compounding is small.

In the present disclosure, the silicon substrate 10 is a monocrystalline silicon substrate. It should be understood that, in other embodiments, the silicon substrate 10 is also a polycrystalline silicon substrate, which is not limited herein.

In this embodiment, the silicon substrate 10 is square in shape, and four corners of the silicon substrate 10 all are chamfers. It should be understood that, in other embodiments, the silicon substrate 10 is in a rectangular, round, oval, triangular, or other shape. The corners of the silicon substrate 10 are in rounded, pointed, or other shapes. The plurality of corners of the silicon substrate 10 have the same shapes, or also have different shapes.

Specifically, the central region 11 refers to a space region that extends outward from a center line of the silicon substrate 10 in a thickness direction. The center line forms a central point on two surfaces of the silicon substrate 10 in the thickness direction. In the thickness direction of the silicon substrate 10, the central region 11 extends outward from the central point, as shown in Fig. 2, Fig. 3, Fig. 4, and Fig. 5. That is to say, the central region 11 is not formed on the surface of the silicon substrate 10; and the central region 11 is the space region having a thickness.

Specifically, the corner edge region 12 refers to a space region that extends from a cutting surface of the corner of the silicon substrate 10 to the center line of the silicon substrate 10. It should be understood that, a cross section of a silicon rod is in a circular shape, and the silicon substrate 10 forms the corner, such that it is necessary to cut the silicon rod to form the cutting surface at the corner. For example, when the corner of the silicon substrate 10 is the chamfer or a rounded corner, the cutting surface is a surface that is formed by cutting the chamfer or the rounded corner.

Further, as described above, the center line forms the central point on the two surfaces of the silicon substrate 10 in the thickness direction. In the thickness direction of the silicon substrate 10, the corner edge region 12 extends from an edge line of the corner of the silicon substrate 10 to the central point, as shown in Fig. 2, Fig. 3, Fig. 4, and Fig. 5. That is to say, the corner edge region 12 is not only formed on the surface of the silicon substrate 10; and the central region 12 is the space region having a thickness.

Specifically, a thickness of the silicon substrate 10 is 30 µm-300 µm, for example, 30 µm, 40 µm, 50 µm, 60 µm, 70 µm, 80 µm, 90 µm, 100 µm, 150 µm, 200 µm, 250 µm, or 300 µm. Therefore, a too low concentration of a photogenerated carrier caused by the too thin silicon substrate 10 is avoided, and the too high cost of a battery caused by the too thick silicon substrate 10 is also avoided.

Specifically, "the conduction type of the central region 11 and the conduction type of the corner edge region 12 being the same" means that the conduction types shown by the central region 11 and the corner edge region 12 are the same. However, this does not represent a limitation on a type of doping elements in the central region 11 and the corner edge region 12.

Further, in some embodiments, the conduction type of the central region 11 and the conduction type of the corner edge region 12 is the same, and both are N types; the central region 11 do not include a P-type doping element, but include an N-type doping element, such that the conduction type of the central region 11 is shown as N-type; the corner edge region 12 do not include an P-type doping element, but include a N-type doping element, such that the conduction type of the corner edge region 12 is shown as N-type; the central region 11 also includes the P-type doping element and the N-type doping element, and a concentration of the at least one N-type doping element is greater than a concentration of the P-type doping element, such that the conduction type of the central region 11 is shown as N-type; and the corner edge region 12 also includes the P-type doping element and the N-type doping element, and a concentration of the at least one N-type doping element is greater than a concentration of the P-type doping element, such that the conduction type of the corner edge region 12 is shown as N-type.

Further, in some embodiments, the conduction type of the central region 11 and the conduction type of the corner edge region 12 also are the same, and both are P types; the central region 11 do not include the N-type doping element, but include the P-type doping element, such that the conduction type of the central region 11 is shown as P-type; the corner edge region 12 do not include the N-type doping element, but include the P-type doping element, such that the conduction type of the corner edge region 12 is shown as P-type; the central region 11 also includes the N-type doping element and the P-type doping element, and the concentration of the P-type doping element is greater than the concentration of the at least one N-type doping element, such that the conduction type of the central region 11 is shown as P-type; and the corner edge region 12 also includes the N-type doping element and the P-type doping element, and the concentration of the P-type doping element is greater than the concentration of the at least one N-type doping element, such that the conduction type of the corner edge region 12 is shown as P-type.

Specifically, a ratio of resistivity of the corner edge region 12 to resistivity of the central region 11 is greater than or equal to 1.2, for example, 1.2, 1.5, 1.8, 2, 3, 4, 7, 8, or the like. Therefore, the resistivity of the corner edge region 12 is greater than the resistivity of the central region 11, facilitating reduction of compounding, thereby improving conversion efficiency.

It should be understood that, the resistivity of the corner edge region 12 is greater than the resistivity of the central region 11, it means that a P-type or N-type doping concentration of the corner edge region 12 is lower, such that P-type or N-type doping elements can be reduced in the corner edge region 12, so as to reduce compounding pairs formed by the doping elements of the corner edge region 12 and oxygen and compounding caused by the doping elements themselves, thereby improving conversion efficiency.

Specifically, resistivity of the central region 11 is greater than or equal to 100 Ω▪cm, for example, 100 Ω▪cm, 120 Ω▪cm, 150 Ω▪cm, 200 Ω▪cm, 400 Ω▪cm, 500 Ω▪cm, 502 Ω▪cm, 550 Ω▪cm, 600 Ω▪cm, 700 Ω▪cm, 800 Ω▪cm, 900 Ω▪cm, or the like. Therefore, the resistivity of the central region 11 is high, and the P-type doping elements or N-type doping elements in the central region 11 are fewer, such that the doping concentration is reduced, thereby reducing the compounding pairs formed by the doping elements and oxygen and the compounding caused by the doping elements themselves.

It should be understood that, for the silicon substrate 10 that is not subjected to high-temperature annealing, the resistivity of the central region 11 is greater than or equal to 10 Ω▪cm, for example, 10 Ω▪cm, 13 Ω▪cm, 50 Ω▪cm, 100 Ω▪cm, 108 Ω▪cm, 191 Ω▪cm, 120 Ω▪cm, 203 Ω▪cm, 711 Ω▪cm, or the like. After the solar cell 1000 is manufactured through high-temperature annealing, an oxygen donor is eliminated, and the resistivity of the central region 11 of the silicon substrate 10 is greater than or equal to 100 Ω▪cm.

Referring to Fig. 1, in some embodiments, the solar cell 1000 includes a first doped layer 21, and the first doped layer 21 is disposed on a first surface of the silicon substrate 10.

Specifically, two surfaces of the silicon substrate 10 in the thickness direction respectively are the first surface and a second surface. It can be that the first surface is a light-facing surface, and the second surface is a backlight surface; and it can also be that the first surface is the backlight surface, and the second surface is the light-facing surface, which is not limited herein.

Specifically, "the first doped layer 21 being disposed on the first surface of the silicon substrate 10" means that the first doped layer 21 is formed through diffusion on the first surface, or may also mean that the first doped layer 21 is formed through deposition on the first surface. Herein, the specific form of disposing the first doped layer 21 on the first surface of the silicon substrate 10 is not limited.

It should be understood that, when the conduction types of the first doped layer 21 and the silicon substrate 10 are the same, a high-low junction is formed between the first doped layer 21 and the silicon substrate 10. When the conduction types of the first doped layer 21 and the silicon substrate 10 are different, a PN junction is formed between the first doped layer 21 and the silicon substrate 10.

Specifically, in some embodiments, the solar cell 1000 further includes a first passivation anti-reflection layer 24 and a first electrode 25. The first passivation anti-reflection layer 24 is stacked on the first doped layer 21. The first electrode 25 is connected to the first doped layer 21 by passing through the first passivation anti-reflection layer 24. The first passivation anti-reflection layer 24 includes at least one of an aluminum oxide layer, a silicon nitride layer, a silicon oxide layer, or a silicon nitride layer. The first electrode 25 includes at least one of a copper electrode, an aluminum electrode, or a silver electrode.

In some embodiments, the first doped layer 21 is a diffusion doped layer.

Therefore, an impurity can be doped in the silicon substrate 10 by using a diffusion process, such that the first doped layer 21 is formed on the silicon substrate 10 to easily realize a high concentration of the first doped layer 21, so as to realize a deep junction depth with the silicon substrate 10, thereby achieving a small surface damage.

It should be understood that, in other embodiments, the first doped layer 21 is also an ion implantation doped layer. Therefore, the number of doped atoms and a doping depth can be better controlled, and a horizontal diffusion effect is small, and a temperature required is low.

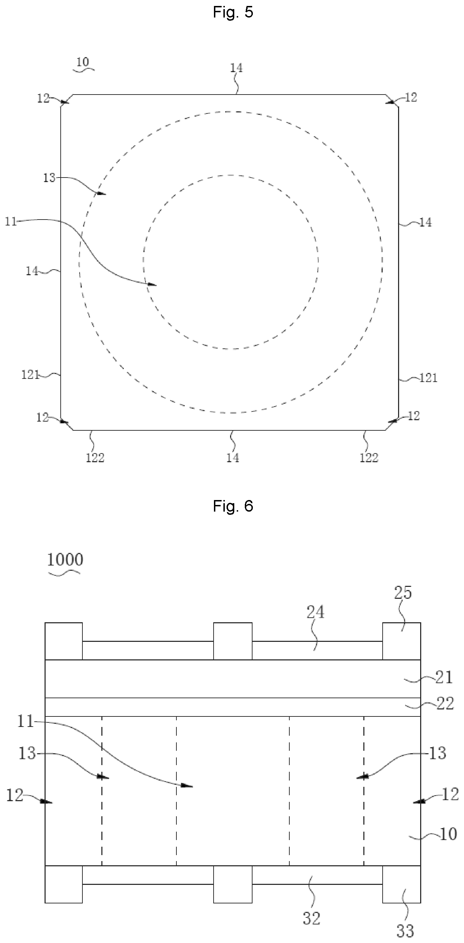

Referring to Fig. 6, in some embodiments, the first doped layer 21 is a doped polysilicon layer or a doped amorphous silicon layer. A first passivation layer 22 is disposed between the first doped layer 21 and the silicon substrate 10, and the first passivation layer 22 is an intrinsic amorphous silicon layer or a silicon oxide layer.

Therefore, the first passivation layer 22 stacked on the silicon substrate 10 and the first doped layer 21 form a passivation contact structure, so as to provide a passivation effect for the solar cell 1000. The first passivation layer 22 causes a plurality of minority carriers to enter the first doped layer 21 through tunneling, and minority compounding is blocked at the same time, such that majority carriers are horizontally transmitted at the first doped layer 21 and collected by a metal electrode of the solar cell 1000, and the compounding of a metal contact region is reduced, thereby increasing an open circuit voltage and short-circuit current of the solar cell 1000.

In an example, the first doped layer 21 is the doped polysilicon layer, and the intrinsic amorphous silicon layer is disposed between the first doped layer 21 and the silicon substrate 10. In another example, the first doped layer 21 is the doped polysilicon layer, and the silicon oxide layer is disposed between the first doped layer 21 and the silicon substrate 10. In yet another example, the first doped layer 21 is the doped amorphous silicon layer, and the intrinsic amorphous silicon layer is disposed between the first doped layer 21 and the silicon substrate 10. In another example, the first doped layer 21 is the doped amorphous silicon layer, and the silicon oxide layer is disposed between the first doped layer 21 and the silicon substrate 10.

It should be understood that, the first passivation layer 22 forms a porous structure. The first doped layer 21 forms the high-low junction or PN junction with the silicon substrate 10 by passing through the first passivation layer 22. The PN junction and the high-low junction formed by the first doped layer 21 and the monocrystalline silicon substrate 10 both are heterojunctions.

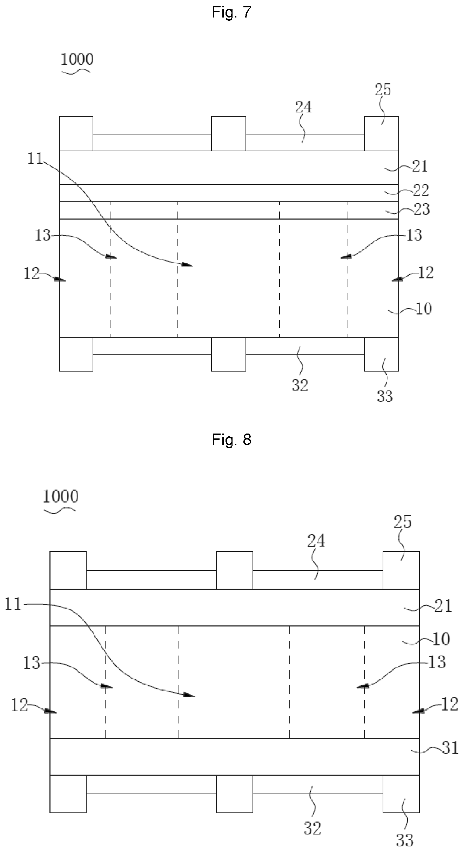

Referring to Fig. 7, in some embodiments, the first doped layer 21 is the doped polysilicon layer. The first passivation layer 22 is disposed between the first doped layer 21 and the silicon substrate 10, and the first passivation layer 22 is the intrinsic amorphous silicon layer or the silicon oxide layer. An internal diffusion layer 23 is formed on the silicon substrate 10; a high-low junction is formed between the internal diffusion layer 23 and the doped polysilicon layer; and a high-low junction or PN junction is formed by the internal diffusion layer 23 and the silicon substrate 10.

Therefore, an internal electric field formed by the internal diffusion layer 23 and the corner edge region 12 is less than an internal electric field formed with the central region 11, such that transmission of current carriers to the central region is promoted, thereby reducing edge compounding.

It should be understood that, since the internal diffusion layer 23 is formed through diffusion of the doped polysilicon layer passing through the first passivation layer 22 to the silicon substrate 10, the conduction types of the internal diffusion layer 23 and the doped polysilicon layer are the same, such that the high-low junction is formed between the internal diffusion layer 23 and the doped polysilicon layer. The conduction type of the silicon substrate 10 is the N-type or the P-type. Thus, the high-low junction or PN junction is formed by the internal diffusion layer 23 and the silicon substrate 10.

That is, when the conduction types of the internal diffusion layer 23 and the silicon substrate 10 are the same (N-type or P-type), the high-low junction is formed by the internal diffusion layer 23 and the silicon substrate 10; and when the conduction types of the internal diffusion layer 23 and the silicon substrate 10 are different, the PN junction is formed by the internal diffusion layer 23 and the silicon substrate 10.

In an example, the first doped layer 21 is the doped polysilicon layer, and the intrinsic amorphous silicon layer is disposed between the first doped layer 21 and the silicon substrate 10. In another example, the first doped layer 21 is the doped polysilicon layer, and the silicon oxide layer is disposed between the first doped layer 21 and the silicon substrate 10.

Referring to Fig. 1, in some embodiments, the solar cell 1000 further includes a second passivation anti-reflection layer 32 and a second electrode 33. The second passivation anti-reflection layer 32 is disposed on the second surface of the silicon substrate 10. The second electrode 33 is connected to the silicon substrate 10 by passing through the second passivation anti-reflection layer 32. The second passivation anti-reflection layer 32 includes at least one of an aluminum oxide layer, a silicon nitride layer, a silicon oxide layer, or a silicon nitride layer. The second electrode 33 includes at least one of a copper electrode, an aluminum electrode, or a silver electrode.

Referring to Fig. 8, in some embodiments, the solar cell 1000 further includes a second doped layer 31, and the second doped layer 31 is disposed on the second surface of the silicon substrate 10. Conduction types of the second doped layer 31 and the first doped layer 21 are different.

Therefore, doped layers are formed on the first surface and second surface of the silicon substrate 10, so as to form the PN junction or high-low junction, such that both surfaces of the solar cell 1000 in the thickness direction can receive light to generate electricity, thereby improving the photoelectric conversion efficiency of the solar cell 1000.

Explanations and descriptions on the second doped layer 31is referred to the first doped layer 21 in the above, and thus are not described herein again to avoid redundancy.

In some embodiments, the solar cell 1000 is a back contact cell. Specifically, the first doped layer 21 and the second doped layer 31 are spaced apart from each other and alternately arranged on one surface of the solar cell 1000. The passivation anti-reflection layer covers the first doped layer 21 and the second doped layer 31. The first electrode 25 is connected to the first doped layer 21 by passing through the passivation anti-reflection layer. The second electrode 33 is connected to the second doped layer 31 by passing through the passivation anti-reflection layer. Similarly, the first passivation layer 22 is also disposed between the first doped layer 21 and the silicon substrate 10. The internal diffusion layer 23 is formed on the silicon substrate 10. Similarly, a second passivation layer is also disposed between the second doped layer 31 and the silicon substrate 10, and the internal diffusion layer is also correspondingly formed.

### Embodiment 2

In some embodiments, the conduction types of the central region 11 and the corner edge region 12 both are N types, the central region 11 and the corner edge region 12 include N-type doping elements, and the N-type doping element includes at least one element in Group V elements and Group VI elements.

Specifically, the fifth main group element includes nitrogen, phosphorus, arsenic, antimony, and bismuth.

Specifically, the sixth main group element includes oxygen, sulfur, selenium, tellurium, and polonium.

That is to say, the doping element of the central region 11 includes at least one of nitrogen, phosphorus, arsenic, antimony, bismuth, oxygen, sulfur, selenium, tellurium, or polonium. The doping element of the corner edge region 12 includes at least one of nitrogen, phosphorus, arsenic, antimony, bismuth, oxygen, sulfur, selenium, tellurium, or polonium. Therefore, various doping elements are provided, such that the doping elements in the central region 11 and the corner edge region 12 are more flexible, and can adopt to more actual production scenarios.

In an example, the doping elements in the central region 11 include oxygen, nitrogen, phosphorus, and arsenic; and the doping elements in the corner edge region 12 include oxygen and nitrogen. In another example, the doping elements in the central region 11 include oxygen and phosphorus; and the doping elements in the corner edge region 12 include antimony and bismuth, which are not limited herein.

### Embodiment 3

In some embodiments, the conduction types of the central region 11 and the corner edge region 12 both are P types, the central region 11 and the corner edge region 12 include P-type doping elements, and the P-type doping element includes at least one element in Group III elements.

Specifically, the third main group element includes boron, aluminum, gallium, indium, and thallium.

That is to say, the doping element in the central region 11 includes at least one of boron, aluminum, gallium, indium, or thallium. The doping element in the corner edge region 12 includes at least one of boron, aluminum, gallium, indium, or thallium. Therefore, various doping elements are provided, such that the doping elements in the central region 11 and the corner edge region 12 are more flexible, and can adopt to more actual production scenarios.

In an example, the doping elements in the central region 11 include boron; and the doping elements in the corner edge region 12 include boron and aluminum. In another example, the doping elements in the central region 11 include gallium; and the doping elements in the corner edge region 12 include boron, which are not limited herein.

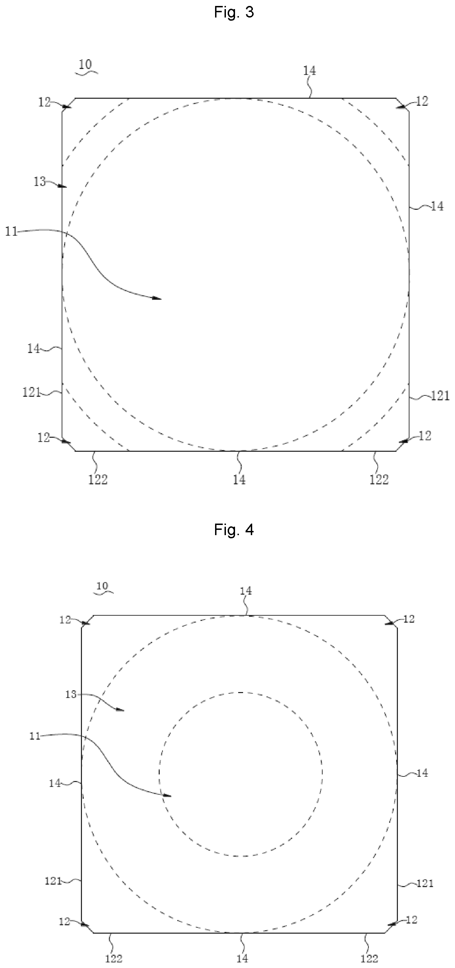

Referring to Fig. 4 and Fig. 5, in some embodiments, the silicon substrate 10 includes a side edge region 14. The side edge region 14 is located between two adjacent corner edge regions 12, a conduction type of the side edge region 14 is the same as the central region 11, and a ratio of resistivity of the side edge region 14 to resistivity of the central region 11 is greater than or equal to 1.2.

Therefore, it can ensure that there are fewer doping elements (P-type doping element or N-type doping element) in the side edge region 14, such that compounding pairs formed by the P-type doping elements or N-type doping elements in the corner edge region 12 and oxygen and the compounding caused by the doping elements themselves are reduced, thereby improving conversion efficiency.

Specifically, the side edge region 14 refers to a space region that extends from a cutting surface of a side length of the silicon substrate 10 to the center line of the silicon substrate 10. It should be understood that, a cross section of a silicon rod is in a circular shape, and the silicon substrate 10 forms a square, such that it is necessary to cut the silicon rod to form the cutting surface at the side length of the square.

Further, as described above, the center line forms the central point on the two surfaces of the silicon substrate 10 in the thickness direction. In the thickness direction of the silicon substrate 10, the side edge region 14 extends from an edge line of the side length of the silicon substrate 10 to the central point, as shown in Fig. 4 and Fig. 5. That is to say, the side edge region 14 is not only formed on the surface of the silicon substrate 10; and the side edge region 14 is the space region having a thickness.

It should be understood that, the side edge region 14 is a region that may be between the corner edge regions 12 on two sides, which is connected to the corner edge regions 12 on the two sides, as shown in Fig. 5. The side edge region 14 is also a boundary point that is between the corner edge regions 12 on the two sides, as shown in Fig. 4. The side edge region 14 is a long side of the silicon substrate 10 that is between the corner edge regions 12 on the two sides, as shown in Fig. 2 and Fig. 3.

### Embodiment 4

Referring to Fig. 2 and Fig. 3, in some embodiments, the central region 11 has a circular surface in a thickness direction of the silicon substrate 10, a center of circle is a central point of the silicon substrate 10, and a radius is 1/5-1/2 of a side length of the silicon substrate 10, for example, 0.2, 0.25, 0.3, 0.35, 0.4, 0.45, 0.48, or 0.5.

Therefore, a size of the central region 11 is within an appropriate range, a small region of low resistivity caused by a too small size is avoided, and a small range of the corner edge region 12, a small region of reduced compounding, and poor effects caused by a too large size is also avoided.

In some embodiments, the radius is 1/2 of the side length of the silicon substrate 10. Therefore, the region of low resistivity is increased as much as possible while a good effect of reducing compounding is achieved.

### Embodiment 5

Referring to Fig. 2, Fig. 3, and Fig. 4, in some embodiments, the corner edge region 12 includes a first corner side 121 and a second corner side 122, a length d1 of the first corner side 121 is 1/100-1/2 of a side length d0 of the silicon substrate 10, and a length d2 of the second corner side 122 is 1/100-1/2 of the side length d0 of the silicon substrate 10.

Therefore, the lengths of two corner sides of the corner edge region 12 are within an appropriate range, so as to cause the corner edge region 12 to be within an appropriate range, such that the small region of reduced compounding and poor effects caused by the corner edge region 12 being too small is avoided, and the small region of low resistivity and a large power generation loss caused by the corner edge region 12 being too large is also avoided.

Specifically, the first corner side 121 and the second corner side 122 respectively refer to portions of the corner edge region 12 of the long side of the silicon substrate 10. It should be understood that, the long side of the silicon substrate 10 does not include an arc-shaped side of a rounded corner or chamfer, but refers to long sides on two ends of the rounded corner or chamfer.

Specifically, a length of the first corner side 121 is, for example, 0.01 of the side length of the silicon substrate 10, 0.08 of the side length of the silicon substrate 10, 0.1 of the side length of the silicon substrate 10, 0.15 of the side length of the silicon substrate 10, 0.2 of the side length of the silicon substrate 10, 0.25 of the side length of the silicon substrate 10, 0.3 of the side length of the silicon substrate 10, 0.35 of the side length of the silicon substrate 10, 0.4 of the side length of the silicon substrate 10, 0.45 of the side length of the silicon substrate 10, or 0.5 of the side length of the silicon substrate 10.

Specifically, a length of the second corner side 122 is, for example, 0.01 of the side length of the silicon substrate 10, 0.08 of the side length of the silicon substrate 10, 0.1 of the side length of the silicon substrate 10, 0.15 of the side length of the silicon substrate 10, 0.2 of the side length of the silicon substrate 10, 0.25 of the side length of the silicon substrate 10, 0.3 of the side length of the silicon substrate 10, 0.35 of the side length of the silicon substrate 10, 0.4 of the side length of the silicon substrate 10, 0.45 of the side length of the silicon substrate 10, or 0.5 of the side length of the silicon substrate 10.

Specifically, the length of the first corner side 121 and the length of the second corner side 122 is the same or different.

It should be understood that, when the lengths of the first corner side 121 and the second corner side 122 are 1/2 of the side length of the silicon substrate 10, a ratio of resistivity of all outer sides of the silicon substrate 10 to the resistivity of the central region is greater than or equal to 1.2, as shown in Fig. 4 and Fig. 5.

### Embodiment 6

In some embodiments, resistivity of the corner edge region 12 is greater than or equal to 500 Ω▪cm, for example, 500 Ω▪cm, 502 Ω▪cm, 800 Ω▪cm, 1000 Ω▪cm, 1002 Ω▪cm, 1100 Ω▪cm, 1200 Ω▪cm, 1500 Ω▪cm, 1800 Ω▪cm, or the like.

Therefore, there are fewer doping elements (P-type doping element or N-type doping element) in the side edge region 12, such that compounding pairs formed by the P-type doping elements or N-type doping elements in the corner edge region 12 and oxygen and the compounding caused by the doping elements themselves are reduced, thereby improving conversion efficiency.

It should be understood that, for the silicon substrate 10 that is not subjected to high-temperature annealing, the resistivity of the corner edge region 12 is greater than or equal to 100 Ω▪cm, for example, 100 Ω▪cm, 110 Ω▪cm, 150 Ω▪cm, 200 Ω▪cm, 483 Ω▪cm, 1059 Ω▪cm, 3523 Ω▪cm, 947 Ω▪cm, 1512 Ω▪cm, or the like. After the solar cell 1000 is manufactured through high-temperature annealing, an oxygen donor is eliminated, and the resistivity of the corner edge region 12 is greater than or equal to 500 Ω▪cm.

### Embodiment 7

Referring to Fig. 2, in some embodiments, an acceptor impurity concentration of the corner edge region 12 is less than an acceptor impurity concentration of the central region 11.

Therefore, the compounding is further reduced, and the photoelectric conversion efficiency of the solar cell 1000 manufactured based on the silicon substrate 10 is improved.

Specifically, the acceptor impurity refers to the P-type doping element. The donor impurity refers to the N-type doping element.

It should be understood that, since the acceptor impurity concentration of the corner edge region 12 is less than the acceptor impurity concentration of the central region 11, the doping elements (P-type doping elements or N-type doping elements) can be reduced in the corner edge region 12, so as to reduce compounding pairs formed by the doping elements of the corner edge region 12 and oxygen and compounding caused by the doping elements themselves, thereby improving conversion efficiency.

### Embodiment 8

Referring to Fig. 2, in some embodiments, a ratio of an acceptor impurity concentration of the central region 11 to an acceptor impurity concentration of the corner edge region 12 is 1.01-10, for example, 1.01, 1.02, 1.05, 1.1, 1.5, 1.8, 2, 3, 5, 8, 9, or 10.

Therefore, by causing the ratio of the acceptor impurity concentration of the central region 11 to the acceptor impurity concentration of the corner edge region 12 within an appropriate range, a relatively flat crystal interface, a relatively slow pulling speed, and a low yield caused by the ratio being too small is avoided, and the crystal interface being more concave to a melt, large thermal stress, and easy wire breakage into polycrystalline caused by the ratio being too large is also avoided.

Referring to Fig. 2, in some embodiments, an acceptor impurity concentration of the corner edge region 12 is less than or equal to 10¹⁵ atoms, for example, 1×10¹⁵ atoms, 0.8×10¹⁵ atoms, 0.5×10¹⁵ atoms, 0.1×10¹⁵ atoms, or the like.

Therefore, by causing the acceptor impurity concentration of the corner edge region 12 to be within an appropriate range, the compounding pairs formed with oxygen and more compounding caused by the doping elements themselves caused by a too large acceptor impurity concentration of the corner edge region 12 is avoided, thereby improving conversion efficiency.

Referring to Fig. 2, Fig. 3, and Fig. 4, in some embodiments, the silicon substrate 10 includes a middle region 13, and the middle region 13 is located between the central region 11 and the corner edge region 12.

Specifically, that the middle region 13 is located between the central region 11 and the corner edge region 12 means that the middle region 13 separates the central region 11 from the corner edge region 12. It should be understood that, the middle region 13 realizes the transition of the concentration of the doping elements between the central region 11 and the corner edge region 12, and can also realize the transition of the resistivity.

### Embodiment 9

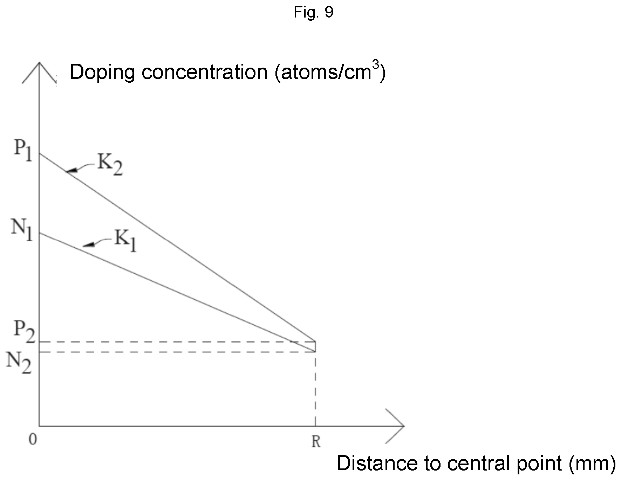

Referring to Fig. 9, in some embodiments, the conduction types of the central region 11 and the corner edge region 12 both are P types, doping elements in the central region 11 and the corner edge region 12 all include at least one P-type doping element and at least one N-type doping element, a doping concentration of the at least one P-type doping element in the central region 11 is greater than a doping concentration of the at least one N-type doping element in the central region 11, and a doping concentration of the at least one P-type doping element in the corner edge region 12 is greater than a doping concentration of the at least one N-type doping element in the corner edge region 12.

A slope absolute value of a concentration curve of the at least one P-type doping element is greater than a slope absolute value of a concentration curve of the at least one N-type doping element.

A horizontal coordinate of the concentration curve of the at least one N-type doping element is a distance between a test position of the silicon substrate 10 and a central point of the silicon substrate 10, and a vertical coordinate is a concentration of the at least one N-type doping element in the test position; and a horizontal coordinate of the concentration curve of the at least one P-type doping element is the distance between a test position and the central point of the silicon substrate 10, and a vertical coordinate is a concentration of the P-type doping element in the test position.

Therefore, since the slope absolute value K₂ of the concentration curve of the at least one P-type doping element is greater than the slope absolute value K₁ of the concentration curve of the at least one N-type doping element, the central point of the silicon substrate 10 is outward, the concentration of the P-type doping element falls more rapidly than the concentration of the at least one N-type doping element, and a difference value between the concentration of the P-type doping element and the concentration of the at least one N-type doping element decreases gradually, thereby ensuring that the ratio of the resistivity of the corner edge region 12 to the resistivity of the central region 11 is greater than or equal to 1.2 when the conduction types of the central region 11 and the corner edge region 12 both are the P types.

Specifically, in an example of Fig. 9, 0 corresponds to the central point of the silicon substrate 10, and R corresponds to a position in the silicon substrate 10 in which the distance to the central point is the maximum. It is apparent that, at the central point of the silicon substrate 10, the doping concentration N₁ of the N-type doping element is less than the doping concentration P₁ of the P-type doping element, thereby ensuring that the conduction type of the central region 11 is the P-type. It is apparent that, in the position in that silicon substrate 10 in which the distance to the central point is the maximum, that is, an outermost edge of the corner edge region 12, the doping concentration N₂ of the N-type doping element is less than the doping concentration P₂ of the P-type doping element, thereby ensuring that the conduction type of the outermost edge of the corner edge region 12 is the P-type. It should be understood that, an extending line of the concentration curve of the at least one N-type doping element and an extending line of the concentration curve of the at least one P-type doping element intersect on the right side of R and located outside the silicon substrate 10, and it ensures that within the silicon substrate 10, the doping concentration of the at least one N-type doping element is less than the doping concentration of the P-type doping element, thereby ensuring the silicon substrate 10 is shown as P-type.

### Embodiment 10

Referring to Fig. 9, in some embodiments, the slope absolute value of the concentration curve of the at least one N-type doping element and the slope absolute value of the concentration curve of the at least one P-type doping element meet the following formula. ${K}_{2} > 1.2 {K}_{1} .$

Where K₁ is the slope absolute value of the concentration curve of the at least one N-type doping element, and K₂ is the slope absolute value of the concentration curve of the at least one P-type doping element.

Therefore, by causing the ratio of the slope absolute value K₂ of the concentration curve of the at least one P-type doping element to the slope absolute value K₁ of the concentration curve of the at least one N-type doping element to be within the appropriate range, it ensures that the ratio of the resistivity of the corner edge region 12 to the resistivity of the central region 11 is greater than or equal to 1.2.

Specifically, the ratio, which is K₂/K₁, of the slope absolute value K₂ of the concentration curve of the at least one P-type doping element to the slope absolute value K₁ of the concentration curve of the at least one N-type doping element is, for example, 1.21, 1.25, 1.3, or 1.4, which is not limited herein.

### Embodiment 11

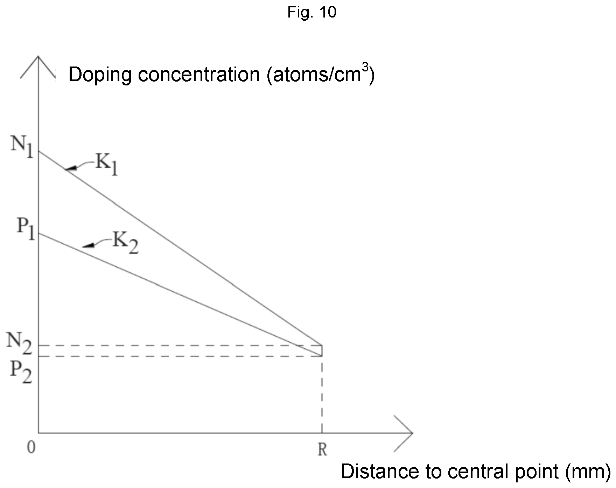

Referring to Fig. 10, in some embodiments, the conduction types of the central region 11 and the corner edge region 12 both are N types, doping elements in the central region 11 and the corner edge region 12 all include at least one P-type doping element and at least one N-type doping element, a doping concentration of the at least one N-type doping element in the central region 11 is greater than a doping concentration of the at least one P-type doping element in the central region 11, and a doping concentration of the at least one N-type doping element in the corner edge region 12 is greater than a doping concentration of the at least one P-type doping element in the corner edge region 12.

A slope absolute value of a concentration curve of the at least one N-type doping element is greater than a slope absolute value of a concentration curve of the at least one P-type doping element.

A horizontal coordinate of the concentration curve of the at least one N-type doping element is a distance between a test position of the silicon substrate 10 and a central point of the silicon substrate 10, and a vertical coordinate is a concentration of the at least one N-type doping element in the test position; and a horizontal coordinate of the concentration curve of the at least one P-type doping element is the distance between a test position and the central point of the silicon substrate 10, and a vertical coordinate is a concentration of the P-type doping element in the test position.

Therefore, since the slope absolute value K₁ of the concentration curve of the at least one N-type doping element is greater than the slope absolute value K₂ of the concentration curve of the at least one P-type doping element, the central point of the silicon substrate 10 is outward, the concentration of the at least one N-type doping element falls more rapidly than the concentration of the P-type doping element, and a difference value between the concentration of the at least one N-type doping element and the concentration of the P-type doping element decreases gradually, thereby ensuring that the ratio of the resistivity of the corner edge region 12 to the resistivity of the central region 11 is greater than or equal to 1.2 when the conduction types of the central region 11 and the corner edge region 12 both are the N types.

Specifically, in an example of Fig. 10, 0 corresponds to the central point of the silicon substrate 10, and R corresponds to a position in the silicon substrate 10 in which the distance to the central point is the maximum. It is apparent that, at the central point of the silicon substrate 10, the doping concentration N₁ of the N-type doping element is greater than the doping concentration P₁ of the P-type doping element, thereby ensuring that the conduction type of the central region 11 is the N-type. It is apparent that, in the position in that silicon substrate 10 in which the distance to the central point is the maximum, that is, an outermost edge of the corner edge region 12, the doping concentration N₂ of the N-type doping element is greater than the doping concentration P₂ of the P-type doping element, thereby ensuring that the conduction type of the outermost edge of the corner edge region 12 is the N-type. It should be understood that, an extending line of the concentration curve of the at least one N-type doping element and an extending line of the concentration curve of the at least one P-type doping element intersect on the right side of R and located outside the silicon substrate 10, and it ensures that within the silicon substrate 10, the doping concentration of the at least one N-type doping element is greater than the doping concentration of the P-type doping element, thereby ensuring the silicon substrate 10 is shown as N-type.

### Embodiment 12

Referring to Fig. 10, in some embodiments, the slope absolute value of the concentration curve of the at least one N-type doping element and the slope absolute value of the concentration curve of the at least one P-type doping element meet the following formula. ${K}_{1} > 1.2 {K}_{2} .$

Where K₁ is the slope absolute value of the concentration curve of the at least one N-type doping element, and K₂ is the slope absolute value of the concentration curve of the at least one P-type doping element.

Therefore, by causing the ratio of the slope absolute value K₁ of the concentration curve of the at least one N-type doping element to the slope absolute value K₂ of the concentration curve of the at least one P-type doping element to be within the appropriate range, it ensures that the ratio of the resistivity of the corner edge region 12 to the resistivity of the central region 11 is greater than or equal to 1.2.

Specifically, the ratio, which is K₁/K₂, of the slope absolute value K₁ of the concentration curve of the at least one N-type doping element to the slope absolute value K₂ of the concentration curve of the at least one P-type doping element is, for example, 1.21, 1.25, 1.3, or 1.4, which is not limited herein.

### Embodiment 13

A solar module in this embodiment of the present disclosure includes the solar cell 1000 in any one of Embodiment I to Embodiment XII.

In the solar module in this embodiment of the present disclosure, since in the solar cell 1000, the conduction types of the central region 11 and the corner edge region 12 of the silicon substrate 10 are the same, the ratio of the resistivity of the corner edge region 12 to the resistivity of the central region 11 is greater than or equal to 1.2, and the resistivity of the central region 11 is greater than or equal to 100 Ω▪cm, it can ensure that there are fewer doping elements (P-type doping elements or N-type doping elements) in the central region 11 and the corner edge region 12, such that the overall doping concentration of the silicon substrate 10 is reduced, and compounding pairs formed by the doping elements and oxygen and the compounding caused by the doping elements themselves is reduced. Furthermore, the resistivity of the corner edge region 12 is greater than the resistivity of the central region 11, such that the concentration of the at least one P-type doping element or N-type doping elements in the corner edge region 12 is further reduced, thereby further reducing the compounding pairs formed by the doping elements in the corner edge region 12 and oxygen and the compounding caused by the doping elements themselves, and further improving conversion efficiency.

In this embodiment, the plurality of solar cells 1000 in the solar module is sequentially connected in series together to form a battery string, so as to realize series convergence output of currents, for example, the serial connection of battery pieces is implemented by means of disposing a ribbon (a bus bar or an interconnection bar), a conductive backboard, etc.

It should be understood that, in such an embodiment, the solar module further includes a metal frame, a backboard, photovoltaic glass, and an adhesive film. The adhesive film is filled between the front side and back side of the solar cell 1000 and the photovoltaic glass, or the adjacent battery pieces, etc. As a filler, the adhesive film is a transparent colloid with good transmittance performance and aging resistance. For example, the adhesive film uses an EVA adhesive film or a POE adhesive film, which is specifically selected according to actual situations, and is not limited herein.

The photovoltaic glass is covered on the adhesive film of the front side of the solar cell 1000. The photovoltaic glass is ultra-clear glass, which has high transmittance, high transparency, and excellent physical, mechanical, and optical properties. For example, the transmittance of the ultra-clear glass reaches over 92%, and the ultra-clear glass may protect the solar cell 1000 without affecting the efficiency of the solar cell 1000 as much as possible. Furthermore, the adhesive film bonds the photovoltaic glass and the solar cell 1000 together, and the presence of the adhesive film performs sealed insulation and protection against water and moisture on the solar cell 1000.

The backboard is attached to the adhesive film on the back side of the solar cell 1000. The backboard protects and supports the solar cell 1000, and has reliable insulation, water resistance, and aging resistance. The backboard may have various options, and usually is tempered glass, organic glass, an aluminum alloy TPT composite adhesive film, etc., which is specifically designed according to specific situations, and is not limited herein. An integral body consisting of the backboard, the solar cell 1000, the adhesive film, and the photovoltaic glass is disposed on the metal frame. The metal frame, as a main external support structure of the entire solar module, performs stable support and mounting on the solar module, for example, the solar module is mounted, through the metal frame, in a position required to be mounted.

### Embodiment 14

A photovoltaic system in this embodiment of the present disclosure includes the solar module in Embodiment XIII.

In the photovoltaic system in this embodiment of the present disclosure, since in the solar cell 1000, the conduction types of the central region 11 and the corner edge region 12 of the silicon substrate 10 are the same, the ratio of the resistivity of the corner edge region 12 to the resistivity of the central region 11 is greater than or equal to 1.2, and the resistivity of the central region 11 is greater than or equal to 100 Ω▪cm, it can ensure that there are fewer doping elements (P-type doping elements or N-type doping elements) in the central region 11 and the corner edge region 12, such that the overall doping concentration of the silicon substrate 10 is reduced, and compounding pairs formed by the doping elements and oxygen and the compounding caused by the doping elements themselves are reduced. Furthermore, the resistivity of the corner edge region 12 is greater than the resistivity of the central region 11, such that the concentration of the at least one P-type doping element or N-type doping elements in the corner edge region 12 is further reduced, thereby further reducing the compounding pairs formed by the doping elements in the corner edge region 12 and oxygen and the compounding caused by the doping elements themselves, and further improving conversion efficiency.

In this embodiment, the photovoltaic system is applied to a photovoltaic power station such as a surface power station, a rooftop power station, a water surface power station, etc., or is also applied to a device or an apparatus that uses solar energy for power generation, such as a user solar power supply, a solar street lamp, a solar car, a solar building, etc. Definitely, it should be understood that, the application scenarios of the photovoltaic system are not limited thereto, that is, the photovoltaic system is used in all fields where solar energy is required for power generation. By using a photovoltaic power generation system network as an example, the photovoltaic system included a photovoltaic array, a combiner box, and an inverter. The photovoltaic array is an array combination of a plurality of cell assemblies. For example, the plurality of cell assemblies constitute a plurality of photovoltaic arrays. The photovoltaic array is connected to the combiner box. The combiner box converges currents generated by the photovoltaic array, and the converged currents are converted into alternating currents required by the municipal power grid by passing through the inverter, and then are connected to the municipal power network, so as to realize solar power supply.

Solar cells manufactured in the related art are used as comparative examples below and compared with the solar cells 100 manufactured in the present disclosure.

The cell manufactured in the related art is used as Comparative example 1. A conduction type of a silicon substrate is an N-type, and resistivity of a central region and a corner edge region is 10. An open circuit voltage is 0.731 V, a short-circuit current is 42.7 mA/cm², a fill factor is 0.845, and conversion efficiency is 26.38%.

Another cell manufactured in the related art is used as Comparative example 2. A conduction type of a silicon substrate is a P-type, and the resistivity of the central region and the corner edge region is 100. An open circuit voltage is 0.741 V, a short-circuit current is 42.8 mA/cm², a fill factor is 0.846, and conversion efficiency is 26.83%.

For the solar cell 100 in an example of the present disclosure, the conduction type of the silicon substrate 10 is the P-type, the resistivity of the central region 11 is 100, the resistivity of the corner edge region 12 is 200, a central point of the silicon substrate is used as the center of circle, and a radius of the central region 11 is 1/5 of a side length of the silicon substrate. An open circuit voltage is 0.743 V, a short-circuit current is 42.8 mA/cm², a fill factor is 0.848, and conversion efficiency is 26.97%.

For the silicon substrate 10 in another example of the present disclosure, the conduction type of the silicon substrate 10 is the N-type, the resistivity of the central region 11 is 100, the resistivity of the corner edge region 12 is 200, the central point of the silicon substrate is used as the center of circle, and the radius of the central region 11 is 1/2 of the side length of the silicon substrate. An open circuit voltage is 0.746 V, a short-circuit current is 42.8 mA/cm2, a fill factor is 0.849, and conversion efficiency is 27.11%.

For the silicon substrate 10 in yet another example of the present disclosure, the conduction types of the silicon substrate 10 is the P-type, the resistivity of the central region 11 is 100, the resistivity of the corner edge region 12 is 200, a central point of the silicon substrate is used as the center of circle, and a radius of the central region 11 is 1/2 of a side length of the silicon substrate. An open circuit voltage is 0.748 V, a short-circuit current is 42.9 mA/cm², a fill factor is 0.851, and conversion efficiency is 27.31%.

It is apparent that, compared to the cells in the related art, the solar cells manufactured in the embodiments of the present disclosure have a higher open circuit voltage, a flat or higher short-circuit current, a higher fill factor, and significantly-improved conversion efficiency.

In the description of the specification, descriptions of the terms "some embodiments," "exemplary embodiment", "example," "specific example," or "some examples", mean that specific features, structures, materials, or characteristics described with reference to the implementations or examples are included in at least one implementation or example of the present disclosure. In this specification, schematic representations of the above terms do not necessarily refer to the same embodiment or example. In addition, the described particular features, structures, materials or characteristics may be combined in any suitable manner in any one or more embodiments or examples.

Furthermore, the above are merely preferred embodiments of the present disclosure, but are not intended to limit the present disclosure. Any modification, equivalent replacement, improvement, or the like made within the spirit and principle of the present disclosure should fall within the protection scope of the present disclosure.

## Claims

1. A solar cell, comprising a silicon substrate, wherein the silicon substrate comprises a central region and a corner edge region, a conduction type of the central region and a conduction type of the corner edge region are the same, a ratio of resistivity of the corner edge region to resistivity of the central region is greater than or equal to 1.2, and the resistivity of the central region is greater than or equal to 100 Ω▪cm.

2. The solar cell according to claim 1, wherein the conduction type of the central region and the conduction type of the corner edge region both are N types, the central region and the corner edge region comprise at least one N-type doping element, and the at least one N-type doping element comprises at least one element in Group V elements and Group VI elements.

3. The solar cell according to claim 1, wherein the conduction type of the central region and the conduction type of the corner edge region both are P types, the central region and the corner edge region comprise at least one P-type doping element, and the at least one P-type doping element comprises at least one element in Group III elements.

4. The solar cell according to claim 1, wherein a projection of the central region onto a surface of the silicon substrate perpendicular to a thickness direction of the silicon substrate is circular, a center of circle is a central point of the silicon substrate, and a radius is 1/5-1/2 of a side length of the silicon substrate.

5. The solar cell according to claim 1, wherein the corner edge region comprises a first corner side and a second corner side, a length of the first corner side is 1/100-1/2 of a side length of the silicon substrate, and a length of the second corner side is 1/100-1/2 of the side length of the silicon substrate.

6. The solar cell according to claim 1, wherein the resistivity of the corner edge region is greater than or equal to 500 Ω▪cm.

7. The solar cell according to claim 1, wherein an acceptor impurity concentration of the corner edge region is less than an acceptor impurity concentration of the central region.

8. The solar cell according to claim 7, wherein a ratio of the acceptor impurity concentration of the central region to the acceptor impurity concentration of the corner edge region is 1.01-10.

9. The solar cell according to claim 1, wherein the conduction type of the central region and the conduction type of the corner edge region both are P types, doping elements in the central region and the corner edge region all comprises at least one P-type doping element and at least one N-type doping element, a doping concentration of the at least one P-type doping element in the central region is greater than a doping concentration of the at least one N-type doping element in the central region, and a doping concentration of the at least one P-type doping element in the corner edge region is greater than a doping concentration of the at least one N-type doping element in the corner edge region;
a slope absolute value of a concentration curve of the at least one P-type doping element is greater than a slope absolute value of a concentration curve of the at least one N-type doping element;
a horizontal coordinate of the concentration curve of the at least one N-type doping element is a distance between a test position of the silicon substrate and a central point of the silicon substrate, and a vertical coordinate is a concentration of the at least one N-type doping element in the test position; and a horizontal coordinate of the concentration curve of the at least one P-type doping element is the distance between a test position and the central point of the silicon substrate, and a vertical coordinate is a concentration of the at least one P-type doping element in the test position.

10. The solar cell according to claim 9, wherein the slope absolute value of the concentration curve of the at least one N-type doping element and the slope absolute value of the concentration curve of the at least one P-type doping element meet the following formula: ${K}_{2} > 1.2 {K}_{1} ;$ wherein K₁ is the slope absolute value of the concentration curve of the at least one N-type doping element, and K₂ is the slope absolute value of the concentration curve of the at least one P-type doping element.

11. The solar cell according to claim 1, wherein the conduction types of the central region and the corner edge region both are N types, doping elements in the central region and the corner edge region all comprises at least one P-type doping element and at least one N-type doping element, a doping concentration of the at least one N-type doping element in the central region is greater than a doping concentration of the at least one P-type doping element in the central region, and a doping concentration of the at least one N-type doping element in the corner edge region is greater than a doping concentration of the at least one P-type doping element in the corner edge region;
a slope absolute value of a concentration curve of the at least one N-type doping element is greater than a slope absolute value of a concentration curve of the at least one P-type doping element;
a horizontal coordinate of the concentration curve of the at least one N-type doping element is a distance between a test position of the silicon substrate and a central point of the silicon substrate, and a vertical coordinate is a concentration of the at least one N-type doping element in the test position; and a horizontal coordinate of the concentration curve of the at least one P-type doping element is the distance between a test position and the central point of the silicon substrate, and a vertical coordinate is a concentration of the P-type doping element in the test position.

12. The solar cell according to claim 11, wherein the slope absolute value of the concentration curve of the at least one N-type doping element and the slope absolute value of the concentration curve of the P-type doping element meet the following formula: ${K}_{1} > 1.2 {K}_{2} ;$ wherein K₁ is the slope absolute value of the concentration curve of the at least one N-type doping element, and K₂ is the slope absolute value of the concentration curve of the P-type doping element.

13. A solar module, comprising the solar cell according to any one of claims 1 to 12.

14. A photovoltaic system, comprising the solar module according to 13.
